# EUROPEAN PATENT APPLICATION

(11) **EP 2 063 345 A2**
(43) Date of publication of application: **27.05.2009**
(21) Application number: 08019092.9
(22) Date of filing: 31.10.2008
(51) Int. Cl.: G06F 3/023, H03M 11/20

(54) **Twin-contact keyboard arrangement**

(30) Priority: 15.11.2007 US 940881
(71) Applicant: POLYCOM, INC., Pleasanton, California 94588 (US)
(72) Inventor: Okunami, Alvin, Cedar Park Texas 78613 (US)
(74) Representative: Käck, Jürgen

(57) **Abstract**

Devices, methods, and techniques for keyboard scanning are disclosed herein. Keyboard arrangements can include a plurality of keys and a keyboard decoder. Each of the plurality of keys can include at least one drive contact and a plurality of sense contacts. Each drive contact can be connected to an output (drive) line (C) of the keyboard decoder, and each sense contact can be connected to an input (sense) line (1 to 7) of the keyboard decoder such that each key is connected to a unique combination of sense lines. Key presses can be identified by the unique combination of sense lines triggered. The combination of sense lines triggered can be used as an address to a lookup table indicating the function of the various keys. Variations of drive signal properties, e.g., frequency, phase, and waveshape, can be used to further distinguish key inputs and/or provide for a greater number of keys and/or corresponding functions.

## Description

### BACKGROUND

This invention relates generally to methods and apparatus for electronic data entry and more particularly to methods and apparatus for matrix keyboard control.

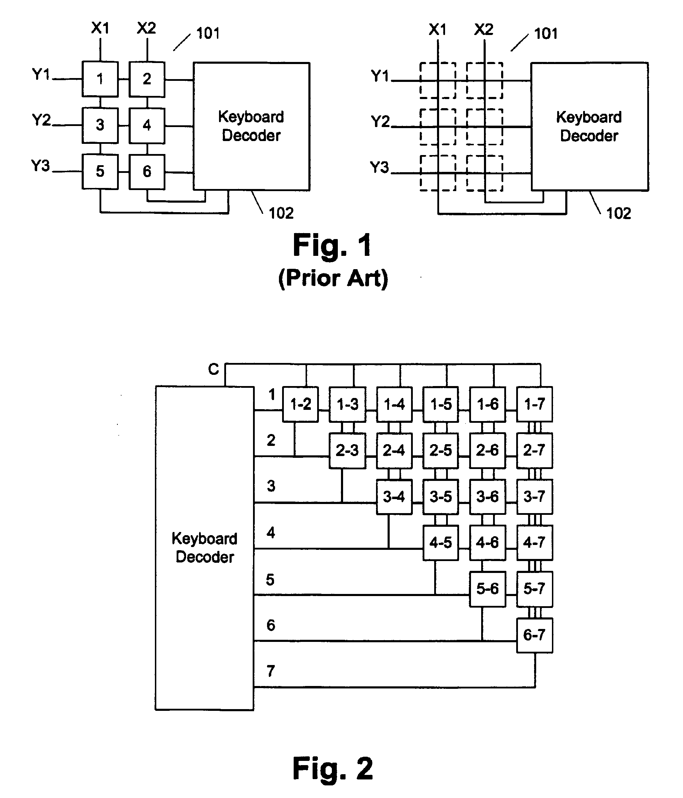

In electronic devices having multiple keys, a matrix switching arrangement can be used to reduce the number of lines required to scan the keys. An exemplary matrix switching arrangement is illustrated in Fig. 1. In the left-hand portion of the figure, a six-key keyboard 101 is schematically illustrated. In the righthand portion of the figure, the keys have been represented with dashed lines showing the "intersection" of the row and column lines, which will be described in greater detail below.

A matrix switching arrangement becomes advantageous over sensing individual keys if more than five keys are involved. For example, 6-key keyboard 101 would require six lines if each key was sensed individually. However, using an X-Y matrix of two columns (X1, X2) and three rows (Y1, Y2, Y3), the number of lines required is reduced to five. As the number of keys increases, the economies of using a matrix arrangement become even greater. For example, a 36-key keyboard would normally require 36 individual lines. However, as few as twelve lines (*e*.*g*., six rows and six columns) can be used if using an X-Y matrix. The row and column lines can be driven and read by a keyboard controller 102. The keyboard controller can be a programmed micro-controller/processor or programmable logic device (CPLD, FPGA, etc.). Alternatively, standard X-Y matrix scanning techniques can also use off-the-shelf keyboard decoder components similar to National Semiconductor's 74C922/923 devices.

Operation of a keyboard like that illustrated in Fig. 1 is well-known to those skilled in the art. Pressing any of the keys 1-6 mechanically initiates either electrical contact or a change in capacitance between the column line and row line uniquely corresponding to the pressed switch. Thus, for example, pressing key 1 will cause either contact or a change in capacitance between column X1 and row Y1. The microprocessor or other keyboard scanning device can apply a drive signal to each column in sequence, and while each drive line (*e*.*g*., columns X1, X2) is being stimulated, each sense line (*e*.*g*., rows Y1, Y2, Y3) can be read to determine whether each key on the currently stimulated line is being pressed. Whether a key is being pressed can be determined based on the nature of the signal appearing on the sense line, which is a function of the electrical contact or change in capacitance caused by the pressed key.

Using devices that operate as described above, the number of available I/O lines is typically at a premium and devices with greater numbers of I/O are more expensive. Therefore, using a smaller number of I/O lines can facilitate the use of a lower cost device. Therefore, keyboard scanning arrangements using fewer lines than an X-Y matrix are desirable.

There have been various analog technqiues proposed to achieve scanning a large number of keys with fewer I/O lines. Such arrangements are described, for example, in the Freescale Semiconductor Application Note entitled, "Multi-Button IR Remote Control Using the MC9RS08KA2" and Microchip "Tips 'n Tricks 8-pin Flash PIC® Microcontrollers Outperform the Compeition," each of which is incorporated by reference in its entirety. These solutions often suffer from decreased reliability because of variations in key resistance, effects of aging on the key contact, and various other parameters.

Therefore, what is needed in the art are improved devices, methods, and techniques for keyboard scanning that use fewer lines than a standard X-Y matrix but maintain sufficiently high levels of reliability.

### SUMMARY

The invention is defined in claims 1, 7 and 13, respectively. In some embodiments, the present invention can relate to a keyboard arrangement. The keyboard arrangement can include a plurality of keys, with each key having a drive contact and a plurality (e.g., two) of sense contacts. The keyboard arrangement can also include a keyboard decoder having at least one output line and a plurality of input lines. The plurality of keys can have their drive contacts connected to the output line or lines of the keyboard decoder, and their drive contacts connected to the input lines of the keyboard decoder. More specifically, the sense contacts of the keys can be connected so that each key is connected to a unique combination of input lines.

In some embodiments, the keyboard decoder, which can be a custom circuit, a programmed microprocessor, an FPGA/CPLD, etc., can be adapted to provide a plurality of different drive signals that vary in phase, frequency, waveshape, etc. In some embodiments, the address formed on the input lines by pressing a key can be used to lookup a function of the key in a lookup table stored in a memory, either integral with or separate from but connected to the keyboard decoder. Values in the lookup table that do not correspond to a valid keypress can be indicated as invalid in the lookup table.

In other embodiments, the invention can relate to a method of decoding keyboard input at a keyboard controller. The method can include reading an address from a plurality of input lines of the keyboard controller, where the input lines are connected to keys of a keyboard substantially as described above, *i*.*e*., each key is connected to a plurality of (*e*.*g*, two) input lines and is connected a unique combination of input lines. The method can also include using the address to look up a key value in a lookup table, and returning the key value stored in the lookup table at the address.

In other embodiments, the method can include determining one or more parameters of a drive signal (*e*.*g*., phase, frequency, or waveshape) associated with the address on the plurality of input lines of the keyboard controller. This parameter or parameters can be used to select an appropriate lookup table for looking up a key value.

These and other embodiments may be understood by reference to the following description and drawings.

### BRIEF DESCRIPTION OF THE DRAWINGS

Figure 1 illustrates a prior art matrix switching arrangement.

Figure 2 illustrates a twin-contact keyboard arrangement.

Figure 3 illustrates a column driver circuit that may be used in conjunction with a twin-contact keyboard arrangement.

Figure 4 illustrates a lookup table for a twin-contact keyboard arrangement.

Figure 5 illustrates an example circuit schematic for a twin-contact key.

Figure 6 illustrates an example PCB layout for a twin-contact key.

Figure 7 illustrates a flowchart of a lookup process using a twin-contact keyboard arrangement.

### DETAILED DESCRIPTION

Disclosed herein is a twin-contact keyboard sensing arrangement, an example of which is schematically depicted in Fig. 2. In a twin-contact arrangement, two "row" (*i*.*e*., "sense") lines and one "column" (*i*.*e*., "drive") line C are connected to each key in such a way that each key has a unique combination of two row lines. For example, in the illustrated embodiment, there are seven row lines 1-7 and a single column line C. The combination of row lines connected to each of the twenty-one keys would be: 1-2, 1-3, 1-4, 1-5, 1-6, 1-7, 2-3, 2-4, 2-5, 2-6, 2-7, 3-4, 3-5, 3-6, 3-7, 4-5, 4-6 4-7, 5-6, 5-7 and 6-7. It should be noted that the keys may be arranged in any shape, and that the shape shown is merely for convenience in illustrating the row and column connection routing.

Unlike typical X-Y matrix switching arrangements that use multiple column lines, the twin contact arrangement can use a single column line. In some embodiments, the single column line can be toggled to produce two separate phases, *e*.*g*., one positive and one negative, effectively doubling the number of keys that can be scanned using the same number of lines. Thus, the arrangement illustrated in Fig. 2 could accommodate an additional twenty-one keys (for a total of forty-two). Using an X-Y matrix arrangement, the same 42-key keyboard would require 13 lines. Toggling between phases can be used to provide a modifier key, such as Shift, Ctrl, Alt, etc. Alternativley, multiple different phases, frequencies, and/or waveshapes can be provided for this purpose.

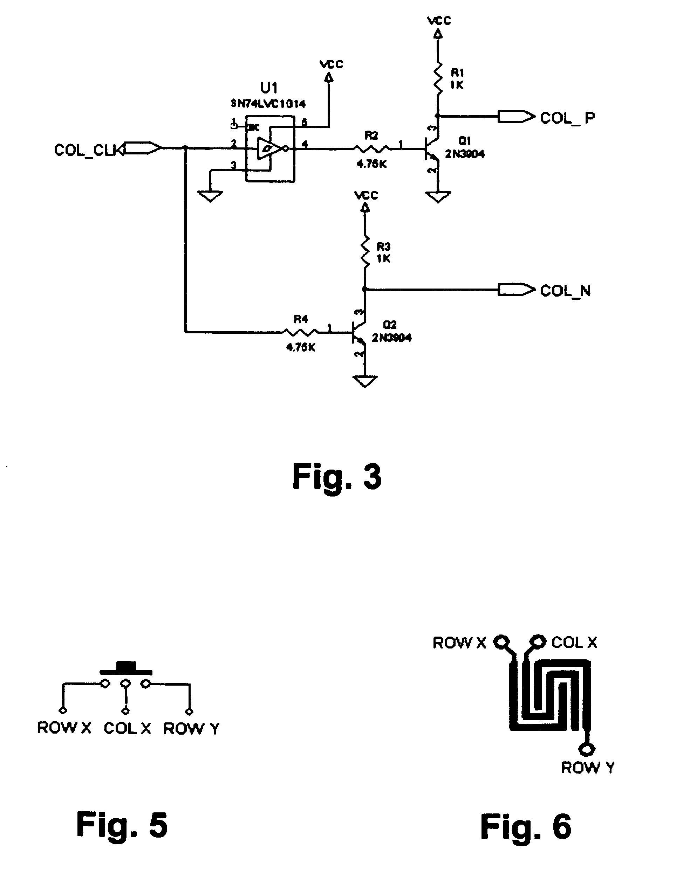

An exemplary two-phase column driver circuit is shown in Figure 3 where an incoming clock signal is inverted to produce both a COL_P and COL_N signal. The rate of the clocking signal COL_CLK determines the fastest rate at which the keyboard can be scanned, for example, 100Hz for a scan time of 10ms. This can be faster or slower depending on the debounce requirements of the particular keys.

An additional advantage of a twin-contact decoding arrangement is that decoding for the keys is simplified, as the row lines form an X-bit address for a look-up table (where X is the number of row lines). The lookup table can be stored in a memory separate from or integral with the keyboard decoder, and can be a read-only memory (ROM) or random access memory (RAM), which could allow the keyboard to be reconfigured for various functions. Where complimentary phases of the column drive signal are used, the row lines can form an X-bit address into twin lookup tables, with the state of the column line being used to select the appropriate lookup table.

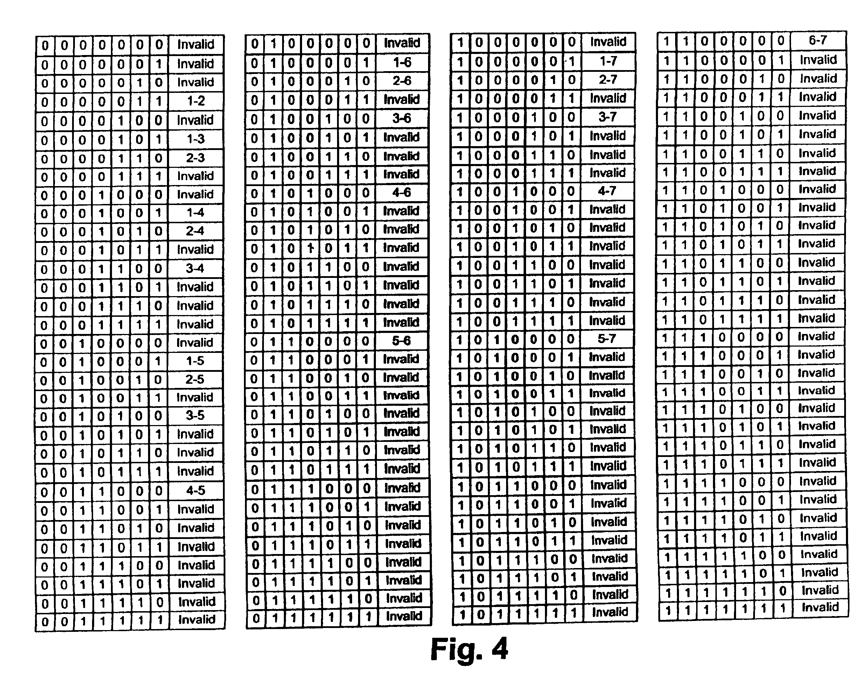

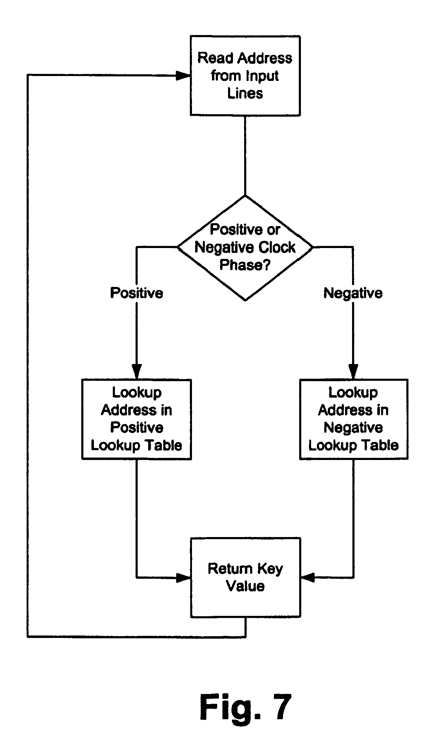

Using the 42-key keyboard as an example, the seven row lines can form a 7-bit address into twin 128 byte lookup tables with the state of the COL_CLK signal used to select which table is used. Twenty-one of the 128 entries are valid in each lookup table with all other entries set to an "invalid" value used by the processing firmware or logic. Additionally, if there is insufficient pressure on a key, such that only one of the two row contacts is closed, it will decode to an "invalid" value and not be processed. An example look-up table for the sensing arrangement of Fig. 2 is illustrated in Fig. 4, and a flow chart of the lookup process is illustrated in Fig. 7.

The table below illustrates the number of lines required between a traditional X-Y matrix keyboard and one using the twin-contact arrangement.

| **# of Keys** | **X-Y Matrix** | **Twin Contact** |
|---|---|---|
| 30 | 11 lines (5 x 6) | 7 lines |
| 42 | 13 lines (6 x 7) | 8 lines |
| 56 | 15 lines (7 x 8) | 9 lines |
| 72 | 17 lines (8 x 9) | 10 lines |
| 90 | 19 lines (9 x 10) | 11 lines |
| 108 | 21 lines (10 x 11) | 12 lines |

An exemplary schematic symbol for a key using the twin-contact arrangement is shown in Figure 5. An exemplary PCB layout footprint for a key using the twin-contact arrangement is shown in Figure 6. As can be seen in either illustration, pressing the key causes an electrical connection (or change in capacitance) between the two row connections and the column connection, allowing the switch to operate as described above. The twin-contact arrangement described herein may be used with a variety of keyboard/switch types, including capacitive, rubber dome, membrane, metal contact, and foam element switches. These devices can also be used in a variety of applications, including computer keyboards, remote controls for entertainment devices and the like, applicance controls, automotive controls, etc.

The foregoing description of preferred and other embodiments is not intended to limit or restrict the scope or applicability of the inventive concepts conceived by Applicant. For example, although twin-contact switching arrangements are illustrated, switching arrangements having greater numbers of sensing contacts are also contemplated. In exchange for disclosing the inventive concepts contained herein, Applicant desires all patent rights afforded by the appended claims. Therefore, it is intended that the appended claims include all modifications and alterations to the full extent that they come within the scope of the following claims or the equivalents thereof.

## Claims

1. A keyboard arrangement comprising:
a plurality of keys, each key having a drive contact and a plurality of sense contacts;
a keyboard decoder having at least one output line and a plurality of input lines;
wherein each of the plurality of keys has its drive contact connected to the at least one output line and its sense contacts connected to different input lines such that each key is connected to a unique combination of input lines.

2. The keyboard arrangement of claim 1 wherein each key has two sense contacts.

3. The keyboard arrangement of claim 1 in which the keyboard decoder is adapted to provide a plurality of drive signals having varying phases, frequencies, and/or waveshapes.

4. The keyboard arrangement of claim 1 further comprising a memory having one or more lookup tables stored therein, wherein the plurality of input lines provide an address for the lookup table and the lookup table stores at one or more addresses a function of the key press corresponding to the one or more addresses.

5. The keyboard arrangement of claim 4 wherein the lookup tables stores an entry of "invalid" for one or more addresses.

6. The keyboard arrangement of claim 4 wherein the memory is integral with the keyboard controller.

7. A method of decoding keyboard input at a keyboard controller, the method comprising:
reading an address from a plurality of input lines of the keyboard controller, wherein the input lines are connected to keys of a keyboard such that each key is connected to a plurality of input lines and is connected to a unique combination of input lines;
using the address to look up a key value in a lookup table; and
returning a key value stored in the lookup table at the read address.

8. The method of claim 7 further comprising determining one or more parameters of a drive signal associated with the address on the plurality of input lines of the keyboard controller wherein using the address to look up a key value in a lookup table further comprises selecting a lookup table based on the determined one or more parameters.

9. The method of claim 8 wherein the determined one or more parameters includes a clock phase.

10. The method of claim 8 wherein the determined one or more parameters includes a waveshape.

11. The method of claim 8 wherein the determined one or more parameters includes a frequency.

12. The method of claim 7 wherein each key is connected to two input lines.

13. A keyboard arrangement comprising:
a plurality of keys, each key having a drive contact and two sense contacts;
a keyboard decoder having at least one output line and a plurality of input lines;
wherein each of the plurality of keys has its drive contact connected to the at least one output line and its sense contacts connected to two input lines such that each key is connected to a unique combination of input lines.

14. The keyboard arrangement of claim 13 in which the keyboard decoder is adapted to provide a plurality of drive signals having one or more varying parameters.

15. The keyboard arrangement of claim 14 wherein the one or more varying parameters are selected from the group consisting of phase, frequency, and waveshape.

16. The keyboard arrangement of claim 14 further comprising a memory having a plurality of lookup tables stored therein, each lookup table corresponding to one of the one or more varying parameters, wherein the plurality of input lines provide an address for the lookup table and the lookup table stores at one or more addresses a function of the key press corresponding to the one or more addresses.

17. The keyboard arrangement of claim 16 wherein the lookup tables stores an entry of "invalid" for one or more addresses.

18. The keyboard arrangement of claim 16 wherein the memory is integral with the keyboard controller.
